# EUROPEAN PATENT SPECIFICATION

(11) **EP 4 689 832 B1**
(45) Date of publication and mention of the grant of the patent: **09.12.2026**
(21) Application number: 23724603.8
(22) Date of filing: 26.04.2023
(51) Int. Cl.: G06F 1/16

(54) **FOLDABLE DISPLAY COMPRISING AN ELASTIC BACKING LAYER**
FALTBARES DISPLAY MIT EINER ELASTISCHEN RÜCKSEITENSCHICHT
ÉCRAN PLIABLE COMPRENANT UNE COUCHE DE SUPPORT ÉLASTIQUE

(43) Date of publication of application: 11.02.2026
(73) Proprietor: Google LLC, Mountain View, CA 94043 (US)
(72) Inventor: HAMBURGEN, William, Riis, Mountain View, California 94043 (US)
(74) Representative: Marks & Clerk GST
(86) International application number: PCT/US2023/020023
(87) International publication number: WO 2024/226046

(56) References cited:
- WO-A1-2023/028547
- US-A1- 2018 348 821
- US-A1- 2021 333 833
- US-A1- 2022 101 761
- US-A1- 2022 238 626

## Description

### BACKGROUND

Devices that include displays may be referred to as display devices. In general, it may be desirable to increase a size of a display (e.g., the area on which images are displayed) as much as possible. Increasing the size of a display may make the device that includes the display large and unwieldy. For instance, devices with larger displays may not fit in pockets, bags, and the like. One way to increase the size of a display without unduly increasing the size of the device is to make the device collapsible such that the display can be folded (e.g., in half). However, folding displays may exhibit creases where the display bends.

WO2023028547A1 discloses a foldable display device that includes: a foldable display layer; and a backing film coupled to the display layer. The backing film has a stiffness in a first direction parallel to a bending axis of a plane of the display layer that is at least ten times higher than a stiffness of the backing film in a second direction perpendicular to the bending axis in the plane of the display layer. The backing film includes a plurality of metal fibers arranged parallel to each other in the first direction and a film that mechanically couples the plurality of metal fibers to each other and that mechanically couples the plurality of metal fibers to the display layer, where the film includes material that has a modulus of elasticity that is less than 3% of a modulus of elasticity of a material of the plurality of metal fibers.

US2022101761A1 discloses a display assembly that has a planar region and an edge bending region that are connected to each other. The display assembly includes a display panel, and a first support portion fixedly connected to a portion of the display panel located in the edge bending region. The first support portion includes a plurality of first support bars, and the plurality of first support bars are spaced apart in a width direction of the edge bending region. Materials of the plurality of first support bars are rigid materials.

US2021333833A1 discloses a cover board and a display panel. The cover board used for the display panel includes a cover board body and reinforcing ribs. The cover board body is made of a flexible material. The reinforcing ribs are disposed within the cover board body. An extension direction of at least part of the reinforcing ribs is perpendicular to a bending direction of the cover board body. The cover board body is provided with the reinforcing ribs to allow the extension direction of the part of the reinforcing ribs to be perpendicular to the bending direction of the cover board body, thereby improving a bending performance of the cover board.

US2018348821A1 discloses a computing device that includes memory configured for storing executable instructions, a processor configured for executing the instructions, a foldable display layer configured for displaying information in response to the execution of the instructions, and a bend limit layer coupled to the foldable display layer and arranged substantially parallel to a display surface of the foldable display layer. The bend limit layer is configured to increase its stiffness non-linearly when a radius of a bend of the bend limit layer is less than a threshold radius of curvature of the foldable display layer, the threshold radius of curvature being greater than 1 mm and less than 20 mm.

US2022238626A1 discloses a display device that includes a display module. A support layer is disposed below the display module. A plurality of support bars is disposed inside the support layer and extends outside of the support layer. Each of the plurality of support bars includes first and second ends that are disposed outside of the support layer. A plurality of joints are configured to receive the first and second ends of the plurality of support bars. The plurality of joints are coupled to each other. The coupled plurality of joints are configured to rotate with respect to each other.

### SUMMARY

According to a first aspect of the invention there is provided a foldable display as specified in appended claim 1.

In general, aspects of this disclosure are directed to folding display devices that include foldable continuous displays. A folding display device may include at least two assemblies (e.g., panels) and a mechanism configured to allow the assemblies to be folded along a folding axis into a collapsed state in which the device is considered closed and an expanded state in which the device is considered open. When the device is in the expanded state, an optical display may be visible and may cover at least a portion of an inner surface of all of the assemblies. As such, the device may be considered to be a continuous display (i.e., because it continues across a boundary between the assemblies). By utilizing such a folding device, the device may include a display with a relatively large length and/or width (e.g., display area) without overly increasing a length and/or width of the device when in the collapsed state. In this way, the "pocketability" of large-screen portable devices may be improved.

A user may interact with the device by touching or otherwise manipulating the continuous display when the mechanism is in the expanded state. When manipulating the continuous display, the display may experience shear forces that generate bending moments along the plane of the continuous display. When folding the mechanism into the collapsed state, a foldable portion of the continuous display between the two assemblies may experience bending forces that generate compressive and/or tensile forces along the foldable portion. To reinforce the foldable portion of the continuous display when the mechanism is in the collapsed state and maintain adequate support for the continuous display when the mechanism is in the expanded state, the continuous display may include a backing layer underlying a display layer. The backing layer includes an elastic matrix or sheet and an array of ribs dispersed in the elastic matrix or sheet that allow independent adjustment of anisotropic properties, such as stiffness in various directions. The elastic matrix or sheet provides an elastic response that supports a bend formed in the foldable portion, and the array of ribs provides a stiff response that resists and/or distributes contact forces, such as shear forces exerted on the continuous display. The array of ribs are aligned parallel to the folding axis to provide mechanical support to the elastic matrix or sheet without interfering with the folding of the foldable portion. In this way, foldable devices described herein may provide adequate support for resisting the various contact forces exerted on the continuous display while also reducing or avoiding creases or other distortions that may otherwise form in the foldable portion due to repeated compressive forces on the continuous display.

In one example, a foldable display includes a continuous display configured to fold around a folding axis. The continuous display includes a display layer that includes an optical display, a cover layer overlaying the display layer, and a backing layer underlying the display layer. The backing layer includes an elastic matrix or sheet and an array of ribs dispersed in or on the elastic matrix or sheet and aligned substantially parallel to the folding axis.

In another example, a folding display device includes a housing and a continuous display coupled to the housing. The housing includes a first assembly, a second assembly, and a hinge assembly coupled to the first and second assemblies and defining a folding axis. The continuous display is and configured to fold around the folding axis and includes a display layer that includes an optical display, a cover layer overlying the display layer, and a backing layer underlying the display layer. The backing layer includes an elastic matrix or sheet and an array of ribs dispersed in or on the elastic matrix or sheet and aligned substantially parallel to the folding axis.

The details of one or more examples are set forth in the accompanying drawings and the description below. Other features, objects, and advantages of the disclosure will be apparent from the description and drawings, and from the claims.

### BRIEF DESCRIPTION OF DRAWINGS

FIG. 1 is a perspective view schematic diagram illustrating a cross-section of a folding device, in accordance with one or more aspects of this disclosure.
FIG. 2A is a side view schematic diagram illustrating a cross-section of a portion of a continuous display of a folding device in an expanded state, in accordance with one or more aspects of this disclosure.
FIG. 2B is a side view schematic diagram illustrating a cross-section of a portion of a continuous display of a folding device in a collapsed state, in accordance with one or more aspects of this disclosure.
FIG. 3A is a perspective view schematic diagram illustrating a portion of a backing layer of a continuous display of a folding device in a flat state, in accordance with one or more aspects of this disclosure.
FIG. 3B is a side view schematic diagram illustrating a cross-section of a portion of a backing layer of a continuous display of a folding device in a bent state, in accordance with one or more aspects of this disclosure.
FIG. 4 is a side view schematic diagram illustrating a cross-section of a portion of a backing layer of a continuous display of a folding device in a flat state, in accordance with one or more aspects of this disclosure.
FIGS. 5A-5C are side view schematic diagrams illustrating a cross-section of a portion of a backing layer that includes ribs dispersed in an elastic matrix, in accordance with one or more aspects of this disclosure.
FIG. 6 is a side view schematic diagram illustrating a cross-section of a portion of a backing layer that includes ribs woven into an elastic matrix, in accordance with one or more aspects of this disclosure.
FIGS. 7A-7C are side view schematic diagrams illustrating a cross-section of a portion of a backing layer that includes ribs positioned beneath an elastic matrix, in accordance with one or more aspects of this disclosure.
FIGS. 8A and 8B are side view schematic diagrams illustrating a cross-section of a portion of a backing layer that includes ribs formed from sheets laminated in an elastic matrix, in accordance with one or more aspects of this disclosure.
FIG. 9 is a flow chart illustrating a method of forming a backing layer of a continuous display of a folding device, in accordance with one or more aspects of this disclosure.

### DETAILED DESCRIPTION

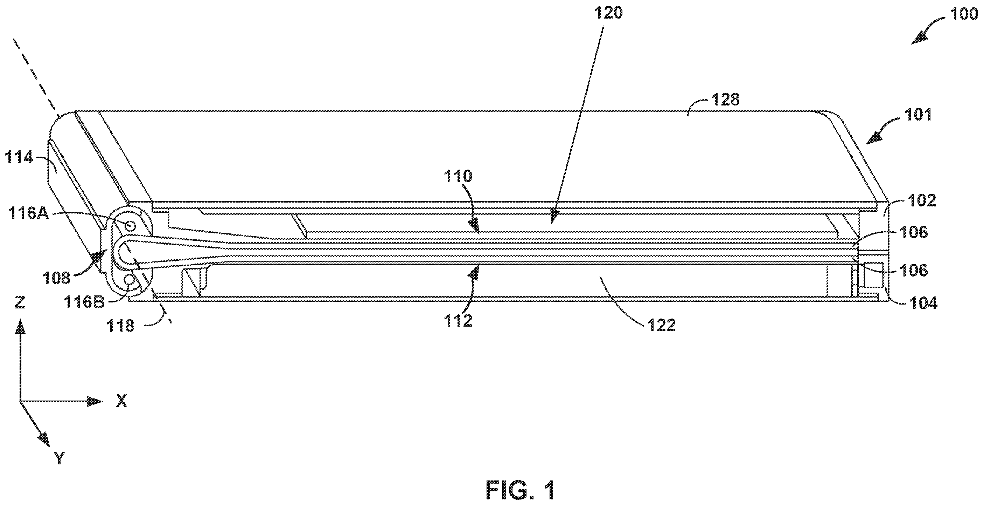

FIG. 1 is a perspective view schematic diagram illustrating a cross section of a folding display device, in accordance with one or more aspects of this disclosure. Examples of device 100 include foldable mobile computing devices such as foldable smart phones, foldable tablets, foldable e-readers, foldable gaming systems, or any other foldable portable device that includes a display.

Device 100 includes a housing 101 and a continuous display 106. Housing 101 includes a first assembly 102, a second assembly 104, and a hinge assembly 114 movably coupled to each of first assembly 102 and second assembly 104. Each of first assembly 102 and second assembly 104 may include an inner surface and an outer surface. The outer surface of first assembly 102 may be visible when looking down at device 100 in the z-axis and the outer surface of second assembly 104 may be visible when looking up at device 100 in the z-axis. The inner surfaces of first assembly 102 and second assembly 104 may not be externally visible when device 100 is closed.

As shown in FIG. 1, first assembly 102 may include main logic board 120 and second assembly 104 may include battery 122. This is merely one example arrangement of components amongst first assembly 102 and/or second assembly 104 and other arrangements are possible. For instance, both first assembly 102 and second assembly 104 may include respective batteries. While not shown in FIG. 1, in some examples, device 100 may include memory configured to store executable instructions and processing circuitry configured to execute the instructions, such that continuous display 106 is configured to display information in response to the execution of the instructions.

Hinge assembly 114 is configured to permit first assembly 102 to rotate about a first axis 116A, defined in the y-direction, and permit second assembly 104 to rotate about a second axis 116B, defined in the y-direction. Hinge assembly 114 defines a folding axis 118 around which at least a portion of continuous display 106 may bend or fold. For example, a position of axis 106A of first assembly 102 and a position of axis 106B of second assembly 104 may be selected such that continuous display 106 may bend or fold around folding axis 118 at a particular position. In some examples, folding axis 118 may be dynamic, such that folding axis 118 retracts into hinge assembly 114 as continuous display 106 folds around folding axis 118.

Continuous display 106 may be capable of rendering data into images viewable by a user of device 100. For example, continuous display 106 may include a matrix of pixels that are individually controllable. Examples of continuous display 1 06 include, but are not limited to, liquid crystal displays (LCD), light emitting diode (LED) displays, organic light-emitting diode (OLED) displays, micro light-emitting diode (microLED) displays, or similar monochrome or color displays capable of outputting visible information to a user of device 100.

In some examples, device 100 may include one or more displays in addition to continuous display 106. For instance, as shown in FIG. 1, device 100 may include a first additional display on the outer surface of first assembly 102 (e.g., display 128). In some examples, device 100 may further include a second additional display on the outer surface of second assembly 104. One or more of continuous display 106, the first additional display, and/or the second additional display may be presence-sensitive displays. In some examples, a presence sensitive display may detect an object at and/or near a screen. As one example range, a presence-sensitive display may detect an object, such as a finger or stylus that is within 2 inches or less of the screen. The presence-sensitive display may determine a location (e.g., an (x,y) coordinate) of a screen at which the object was detected. In another example range, a presence-sensitive display may detect an object six inches or less from the screen and other ranges are also possible. The presence-sensitive display may determine the location of the screen selected by a user's finger using capacitive, inductive, and/or optical recognition techniques. In some examples, presence sensitive display also provides output to a user using tactile, audio, or video stimuli.

Continuous display 106 is coupled to housing 101, such that relative movement between first assembly 102 and second assembly 104 translates to folding movement of continuous display 106. Continuous display 106 includes first rigid segment 110 attached to first assembly 102 (e.g., positioned on the inner surface of first assembly 102 and coplanar with the inner surface of first assembly 102), a flexible segment 108, and second rigid segment 112 attached to second assembly 104 (e.g., positioned on the inner surface of second assembly 104 and coplanar with the inner surface of first assembly 102). Flexible segment 108 may connect the rigid segment of one side of device 100 to the rigid segment of the other side of device 100. In some implementations, continuous display 106 can include zero, one, or more than two rigid segments 110, 112 and more than one flexible segment 108. For example, when continuous display 106 includes zero rigid segments, continuous display 106 may be continuously bendable, and can be rolled up, as in a scroll, while when continuous display 106 includes two flexible segments, continuous display 106 may be folded twice (e.g., into a "Z" shape).

Flexible segment 108 is configured to fold around folding axis 118 defined by hinge assembly 114. For example, flexible segment 108 may be configured to fold at least 180 degrees (e.g., to facilitate closure of device 100). When device 100 is fully opened about hinge assembly 114, an inner surface of first assembly 102 is substantially coplanar with an inner surface of second assembly 104. When device 100 is fully closed about hinge assembly 114, flexible segment 108 is configured to fold around folding axis 118 to a bend radius.

As will be described further below, continuous display 106 includes a backing layer that is configured to reinforce continuous display 106 when device 100 is fully opened and maintain adequate support for continuous display 106 when device 100 is fully closed. The backing layer is formed from a composite material that exhibits an elastic response to bending forces around folding axis 118 and a stiff response to contact forces, such as normal and/or shear forces, exerted on continuous display 106. As a result, continuous display 106 may have a small form factor that is less susceptible to damage, such as creases and cracks, caused by repeated opening and closing of device 100 and/or less susceptible to damage, such as delamination, caused by repeated shear forces exerted on continuous display 106.

While described herein with respect to folding display devices, the backing layers may be used for other applications for which anisotropic stiffness in a thin layer may be desired, such as non-display electronic components (e.g., flex circuit ruggedization), non-display electronic systems (e.g., bendable smart tags), or mechanical components (e.g., personal protective equipment).

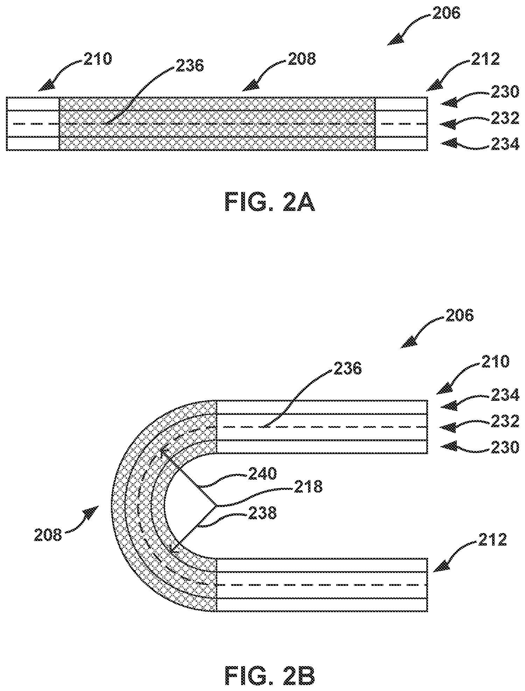

FIG. 2A is a side view schematic diagram illustrating a cross-section of a portion of a continuous display 206 of a folding device, such as continuous display 106 of folding device 100, in an expanded state, in accordance with one or more aspects of this disclosure. As shown in FIG. 2A, continuous display 206 includes a first rigid segment 210, a second rigid segment 212, and a flexible segment 208 that allows continuous display 106 to bend about an axis (not labelled in FIG. 2A).

To keep a form factor of a corresponding folding device small and slim, continuous display 206 may be relatively thin. However, folding a relatively thin display may result in bends having a small radius at a folding axis in continuous display 206. These bends may generate compressive and tensile forces that can be detrimental to sensitive components, such as thin film transistors (TFTs), organic light-emitting diodes (OLEDs), thin-film encapsulation (TFE), and the like. In addition, thin displays can be relatively fragile and in need of protection against breakage or cracking from contact forces, such as impacts or shear forces, to the front surface of device 100.

To support a thin form factor, continuous display 206 may be assembled as a stack of layers joined by an adhesive, such as an optically clear adhesive (OCA). In the example of FIG. 2A, continuous display 206 includes a display layer 232, a cover layer 230 overlying display layer 232, and a backing layer 234 underlying display layer 232; however, continuous displays may include additional layers. The various layers of continuous display 206 may be assembled to define a neutral plane 236. Neutral plane 236 may represent a dimension that remains substantially constant in response to bending. For example, when continuous display 206 is bent, neutral plane 236 may define a boundary between compressive forces generated interior to neutral plane 236 due to a reduced length and tensile forces generated exterior to neutral plane 236 due to an increased length, such that a length of neutral plane 236 may be relatively constant.

Display layer 232 includes an optical display. The optical display may include any visual interface configured to generate imagery in response to an electrical signal. For example, the optical display may include an organic light-emitting diode (OLED) display or a micro light emitting diode display. Display layer 232 may include a polyimide substrate with barrier, thin film transistor (TFT), organic light-emitting diode (OLED) or micro light-emitting diode (MLED), and encapsulation layers. In some examples, display layer 232 may include additional layers, such as a touch sensitive layer. For example, a touch sensitive layer providing touch functionality may be positioned directly on top of the optical display, which may reduce a thickness of fragile layers, such as OLED or MLED layers, and simplify electrical connection to the touch layer. Cover layer 230 is configured to provide protection to display layer 232, such as from impact or bending. Cover layer 230 may include a cover window, such as a user-facing cover window film. In some examples, cover layer 230 may include additional layers, such as a polarization layer or other functional optical layer.

Cover layer 230, display layer 232, and backing layer 234 may be separately manufactured and modularly assembled into continuous display 206. Display layer 232 may be manufactured using a complex process that may not be easily altered to meet customer-specific requirements. In contrast, cover layer 230 and/or backing layer 234 may be manufactured using simpler processes that may be altered to meet customer-specific requirements.

A folding behavior of a display layer, including particular forces exerted on the display layer, may be specific to a particular form factor and internal arrangement of components of a specific device, which may include a customer-specific cover layer and/or backing layer. A device that includes backing layers and cover layers that do not adequately support the folding behavior of the device may cause damage to a display layer of the device. For example, the backing layer may cause the display layer to exceed a minimum radius or cause a neutral plane of the device to shift away from the display layer, which may be detrimental to the in-system folding cycle life of a display of the device. However, bulk properties of a material of the backing layer that modify the shape of the bend or the position of the neutral plane, such as elasticity, may result in the backing layer having a high thickness and/or reduced support of other portions of the display that are not subject to bending, such as non-flexible segments that are subject to contact forces.

FIG. 2B is a side view schematic diagram illustrating a cross-section of a portion of continuous display 206 of a folding device in a collapsed state, in accordance with one or more aspects of this disclosure. Continuous display 206 may be in the collapsed state when the corresponding device is in a fully closed state, such as illustrated in FIG. 1. Flexible segment 208 of display 206 is configured to permit display layer 232 of display 206 to bend in an arc defined by a folding axis 218. When bent to the arc, continuous display 206 is defined by an inner radius 238 from folding axis 218 to an outer surface of display layer 232, and an average radius 240 from folding axis 218 to neutral plane 236.

Backing layer 234 is configured to support continuous display 206 in response to both bending and shear forces exerted on continuous display 206. As one example, continuous display 206 may be subjected to repeated folding and/or rolling stresses over a large area. To support continuous display 206 in response to such bending forces, backing layer 234 may be configured to bend and stretch easily in preferred directions, such bend around the folding axis and stretch perpendicular to the folding axis. As another example, continuous display 206 may be subjected to contact that imparts stresses over a localized area. To support continuous display 206 in response to such shear forces, backing layer 234 may be configured to resist and distribute the shear forces.

In some examples, backing layer 234 may support continuous display 206 in response to shear forces such that continuous display 206 may permit an amount of displacement of display layer 232 to resist delamination between display layer 232 and backing layer 234 and/or limit an amount of displacement of display layer 232 to reduce damage to display layer 232 that may result from deformation. Such support may be represented by a stiffness of backing layer 234 in response to shear forces that are parallel to a surface of backing layer 234. In some examples, backing layer 234 may have a stiffness in response to shear forces that is at least 10 times a stiffness in response to bending forces.

In some examples, backing layer 234 may support continuous display 206 in response to bending forces such that flexible segment 208 may form radii 238, 240 that are sufficiently large to limit compressive and tensile forces on display layer 232. Such a limit to the compressive and tensile forces may be represented by a minimum radius. This minimum radius may be selected to prevent display layer 232 from bending in a radius so small that fragile components of display layer 232 would be broken. Display layer 232 may be configured to be bent repeatedly, such as to a radius of less than 10 mm. In some examples, the minimum radius may be greater than or equal to 2.5 millimeters, or greater than or equal to 3.0 millimeters, or greater than or equal to 5 millimeters.

In some examples, backing layer 234 may further limit compressive and/or tensile forces by forming radius 240 such that neutral plane 236 is positioned within or radially inward of display layer 232. For example, display layer 232 may be particularly susceptible to cracks or ripples that form due to compressive forces. By positioning neutral plane 236 within or radially inward of display layer 232, compressive forces may be reduced, eliminated, and/or balanced with tensile forces. In some examples, neutral plane 236 of continuous display 206 may be positioned within a middle 50% of display layer 232, such as a middle 20% of display layer 232.

In some examples, backing layer 234 may have an increased resistance to a force or become rigid when inner radius 238 and/or average radius 240 of flexible segment 208 reaches a specified minimum radius. For example, flexible segment 208 may be relatively flexible when bent in a radius greater than the minimum radius and then become rigid when the bend radius approaches, is equal to, or is smaller than the minimum radius. Such an increase in resistance with respect to degree of bending may be a relatively gradtial increase, such as a linear increase when inner radius 238 and/or average radius 240 is near the minimum radius, or may be a relatively abrupt increase, such as a step function. Backing layer 234 may be configured to increase its stiffness non-linearly when a radius of a bend of backing layer 234 is less than a threshold radius of curvature. For example, the threshold radius of curvature may be greater than 1 mm and less than 20 mm.

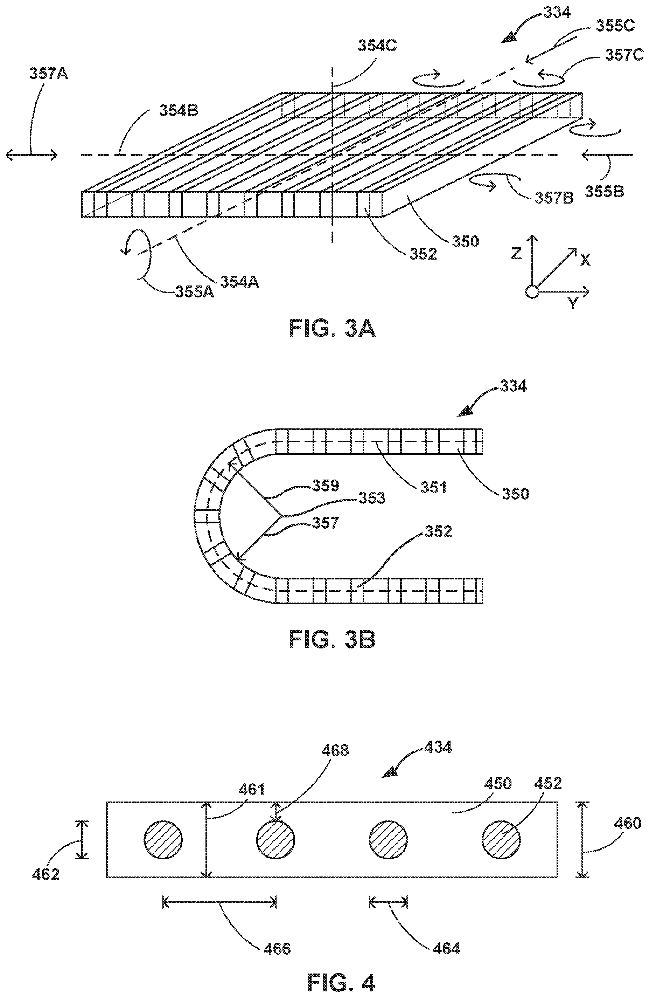

Display devices described herein include a backing layer formed from a composite material that exhibits anisotropic stiffness, such that an otherwise stiff backing layer is flexible around a folding axis. FIG. 3A is a perspective view schematic diagram illustrating a portion of a backing layer 334 of a continuous display of a folding device, such as continuous display 106 of device 100 of FIG. 1, in a flat state, in accordance with one or more aspects of this disclosure. To provide such anisotropic behavior, backing layer 334 includes an elastic matrix or sheet 350 (referred to herein as "elastic matrix 350" for simplicity) and an array of ribs 352 dispersed in or on elastic matrix 350 and aligned substantially parallel to a folding axis 353, parallel to x-axis 354A in FIG. 3A, of the device. The array of ribs 352 may be substantially stiffer than elastic matrix 350, such that deformation of backing layer 334 may be limited to stretching perpendicular to folding axis 353 and folding around folding axis 353. As a result, the array of ribs 352 may be configured to provide supportive properties to backing layer 334 when the device is in a flat state, such as in response to shear forces, while elastic matrix 350 may be configured to provide supportive properties to backing layer when the device is in a bent state, such as in response to bending forces.

FIG. 3B is a side view schematic diagram illustrating a cross-section of a portion of a backing layer of a continuous display of a folding device in a bent state, in accordance with one or more aspects of this disclosure. Backing layer 334 is illustrated as bending around folding axis 353. An extent of bending may be characterized by a minimum radius 357 between folding axis 353 and an inner surface of backing layer 334 configured to contact a display layer, and an average radius 359 between folding axis 353 and a central plane 351 of backing layer 334. Minimum radius 357 and/or average radius 359 may be configured based on a desired minimum radius of an adhered display layer.

Referring back to FIG. 3A, during operation, backing layer 334 may be subject to various bending and shear forces. When the device is in a bent state, backing layer 334 may subject to a bending force 353A around x-axis 354A that creates a tensile force 355A along y-axis 354B due to expansion of elastic matrix 350 near a bend. When the device is in a flat state, backing layer 334 may be subject to a shear force 355B along y-axis 354B that creates a rotational moment 357B, and a shear force 355C along x-axis 354A that creates a rotation moment 357C. Backing layer 334 may be configured to resist the shear forces 355B and 355C along y-axis 354B and x-axis 354A, respectively, while accommodating bending force 355A such that the display layer (not shown) is bent to a desired radius.

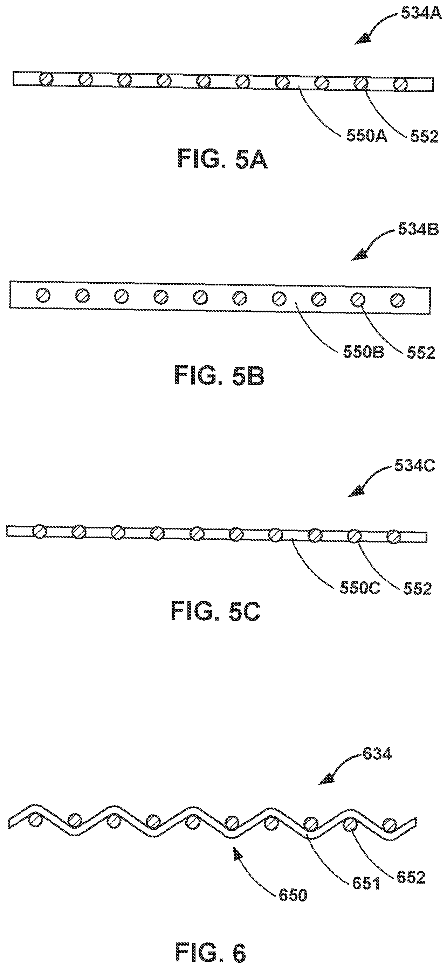

Without being limited to any particular theory, various stiffnesses of backing layer 434 may be expressed based on bulk material and structural properties, such as elastic modulus and thickness, of each of elastic matrix 350 and ribs 352. Equations 1-3 below may represent stiffness of backing layer 334 having cross-sectionally rectangular ribs 352 dispersed in elastic matrix 350; however, a stiffness of backing layer 335 in response to various bending and/or shear forces may be represented by other equations that account for ribs 352 and elastic matrices 350 that include other configurations, such as described in FIGS. 5-8 below.

Stiffness of backing layer 334 in response to tensile force 357A caused by bending force 355A may be represented by the following general equation:
[Equation 1] ${k}_{T} = {E}_{R} ⋅ {T}_{R} ⋅ \frac{P}{P - B}$

In Equation 1 above, k_{T} may represent stiffness in response to tensile force 357A created by bending force 355A, E_{R} may represent an elastic modulus of elastic matrix 350, T may represent the thickness of rib 352, P may represent a centerline spacing between adjacent ribs 352, and B may represent a width of rib 352. Stiffness of backing layer 334 in response to rotational moment 355B caused by shear force 357B along y-axis 354B may be primarily limited by properties of the array of ribs 352, and may represented by the following general equation:
[Equation 2] ${k}_{My} = {E}_{R} ⋅ {{T}_{R}}^{3} ⋅ \frac{B}{12 P}$

In Equation 2 above, k_{My} may represent stiffness in response to rotational moment 357B created by shear force 357B, E_{R} may represent an elastic modulus of rib 352, T may represent a thickness of rib 352, B may represent a width of rib 352, and P may represent a centerline spacing between adjacent ribs 352. Stiffness of backing layer 334 in response to a rotational moment 355C caused by shear force 357C along x-axis 354A may be primarily limited by properties of elastic matrix 350, and may be represented by the following general equation:
[Equation 3] ${k}_{Mx} = {E}_{E} ⋅ {{T}_{E}}^{3} ⋅ \frac{P}{12 \left(P-B\right)}$

In Equation 3 above, k_{Mx} may represent stiffness in response to rotational moment 355C created by shear force 357C, E_{E} may represent an elastic modulus of elastic matrix 350, T may represent a thickness of elastic matrix 350, and P may represent a centerline spacing between adjacent ribs 352, and B may represent a width of rib 352.

As illustrated in Equations 1-3 above, various material and structural properties of elastic matrix 350 and the array of ribs 352 may be selected to configure backing layer 334 with a particular response to bending and shear forces. FIG. 4 is a side view schematic diagram illustrating a cross-section of a portion of a backing layer of a continuous display of a folding device in a flat state, in accordance with one or more aspects of this disclosure. Backing layer 434 may have a thickness 462. Thickness 462 may represent a greatest dimension of backing layer 434 perpendicular to a major surface of backing layer 434. In some examples, a thickness 461 of backing layer 434 is less than about 1 millimeter.

The array of ribs 452 may be configured with properties configured to provide stiffness to backing layer 434 in response to forces other than folding forces. Each rib 452 has a thickness 462 and a width 464. As illustrated in Equation 1 above, a thickness and elastic modulus of ribs 452 may be configured to increase stiffness of backing layer 434 in response to forces other than folding moments around the folding axis and/or stretching forces perpendicular to the folding axis. While thickness 462 is illustrated as uniform among the array of ribs 452, in some examples, the array of ribs 452 may include ribs having varying thicknesses. For example, as illustrated above, a thickness of ribs 452 may be related to a stiffness of backing layer 434, such that portions of backing layer 434 for which a greater amount of stiffness may be desired may have thicker ribs 452. In some examples, a thickness 462 of array of ribs 452 is less than about 500 micrometers, such as from about 10 micrometers to about 200 micrometers. In some examples, width 464 is between about 50 micrometers and about 1 millimeter, such as from about 100 micrometers to about 300 micrometers. In some examples, the array of ribs 452 have an elastic modulus greater than about 1 gigapascal (GPa), such as greater than about 50 GPa. In some examples, the array of ribs 452 include at least one of a metal, a carbon reinforced plastic, or a fused silica fiber. For example, an elastic modulus of steel may be about 200 GPa, aluminum about 70 GPa, and fused silica about 70 GPa. In some examples, the array of ribs may have a high degree of flatness (e.g., longitudinal flatness across backing layer 434, short-span flatness across a portion of backing layer 434).

Ribs 452 may have a variety of cross-sectional shapes. While illustrated in FIG. 4 as having a round shape, ribs 452 may have a square shape, rectangular shape, star shape, or any other cross-sectional shape. In some examples, ribs 452 may have a cross-sectional shape that has a relatively high ratio of perimeter to area, such that ribs 452 have a high surface area for adhering to an elastic matrix or sheet 450 (herein, "elastic matrix 450"). For example, a star-shape rib may have a large surface area that contacts an elastic matrix.

Adjacent ribs of the array of ribs 452 are separated by a spacing 466. A variety of spacings may be used, such as from about 50 micrometers to about 1 millimeter, or about 100 micrometers to about 300 micrometers. In some examples, spacing 466 may be defined relative to width 464, such as from about width 464 to about ten times width 464. Spacing 466, in combination with thickness 464, may be configured to provide a particular relative ratio of elastic matrix 450 to ribs 452. For example, a higher spacing 466 may result in backing layer 434 having a higher proportion of elastic matrix 450, and thus a lower stiffness along y-axis 354B. Spacing 466 of ribs 452 inside a flexible segment, such as flexible segment 108 of FIG. 1, is different from spacing 466 of ribs 452 outside the flexible segment.

Spacing 466 may change based on whether the device is in the collapsed or expanded state. For example, when the device is in an expanded state, a portion of backing layer 434 within the flexible segment may stretch, such that spacing 466 may increase in the portion. In some examples, the array of ribs 452 may be offset 468 from a surface of backing layer 434. For example, a surface portion of elastic matrix 450 may better adhere to an overlying layer and/or may distribute localized pressure over a greater area than the array of ribs 452. Offset 468 may be greater than about 50 micrometers.

Elastic matrix 450 may be configured with properties configured to provide flexibility to backing layer 434 in response to bending forces and/or support to backing layer 434 in response to shear forces. The various properties may be selected so that backing layer 434 exhibits a desired bend radius in response to bending forces around a folding axis of the corresponding device. Elastic matrix 450 has a thickness 461. In some examples, such as examples in which elastic matrix 450 is formed in discrete segments, each segment may have a width that corresponds to a difference between spacing 466 and width 464 of ribs 452. As illustrated in Equations 1 and 3 above, a thickness and elastic modulus of elastic matrix 450 may be related to a stiffness of backing layer 434 in response to bending forces around the folding axis and/or shear forces along the folding axis. In some examples, thickness 461 of elastic matrix 450 is less than about 1 millimeter. In some examples, elastic matrix 450 includes an elastic material having an elastic modulus less than about 2 Gigapascal (GPa), such as less than about100 megapascal (MPa). In some examples, the elastic material includes at least one of an ethylene propylene diene monomer (EPDM) rubber, nitrile rubber, thermoplastic polyurethane (TPU), silicone, O-carboxyanhydride (OCA), acrylate, or nylon. For example, an elastic modulus of nylon may be about 2 GPa, EDPM about 7 MPa, and OCA about 0.3 MPa. In some examples, an elastic modulus of the array of ribs 352 may be at least 10,000 times greater than an elastic modulus of elastic matrix 450.

Backing layers described herein may have a variety of configurations. FIGS. 5A-5C are side view schematic diagrams illustrating a cross-section of a portion of backing layers 534A, 534B, 534C that include an array of ribs 552 dispersed in elastic matrices 550A, 550B, 550C, in accordance with one or more aspects of this disclosure. In the examples of FIGS. 5A-5C, each backing layer 534A, 534B, 534C includes an array of ribs 552 embedded in a respective elastic matrix 550A, 550B, 550C. Referring to FIG. 5A, backing layer 534A includes elastic matrix 550A that is planar with the array of ribs 552, such that a thickness of elastic matrix 550A is about equal to (e.g., within about 5%) of a thickness of the array of ribs 552. As a result, an overall density of backing layer 534A may be relatively high and an overall thickness of backing layer 534A relatively small compared to backing layers that are over- or under-filled.

However, in some instances, an overfilled or underfilled backing layer may be desirable. Referring to FIG. 5B, backing layer 534B includes elastic matrix 550B that is not planar with the array of ribs 552, such that a thickness of elastic matrix 550B is greater than a thickness of the array of ribs 552 (i.e., over-filled). Such a greater thickness may provide a surface portion elastic matrix 550B between the array of ribs 352 and an overlying layer, such as the display layer. This surface portion may provide an increased local elasticity at the interface between the overlying layer and the array of ribs 552. In some examples, elastic matrix 550B may better adhere to the overlying layer or an adhesive between elastic matrix 550B and the overlying layer.

Referring to FIG. 5C, backing layer 534C includes elastic matrix 550C that is not planar with the array of ribs 552, such that a thickness of elastic matrix 550C is less than a thickness of the array of ribs 552 (i.e., under-filled). Such a lesser thickness may provide an air gap between elastic matrix 550C and an overlying layer, such as the display layer. The array of ribs 552 may be adhered to the overlying layer, and the air gap may enable elastic matrix 550C to change shape (e.g., stretch or compress) without adhering to the overlying layer, thereby functioning as expansive webbing between the adhered ribs 552.

In some examples, backing layers described herein may be formed by discrete fibers or threads. FIG. 6 is a side view schematic diagram illustrating a cross-section of a portion of a backing layer 634 that includes an array of ribs 652 woven into an elastic matrix 650, in accordance with one or more aspects of this disclosure. Elastic matrix 650 includes an array of elastic fibers 651 aligned substantially perpendicular to a folding axis of the corresponding continuous display, such that the array of elastic fiber 651 are perpendicular to the array of ribs 652. The array of elastic fibers 651 is woven with the array of ribs 652 to form elastic matrix 650 having a woven fabric structure that supports the array of ribs 652. As such, various properties of the array of elastic fibers 651, such as a spacing between adjacent elastic fibers 651 or a pattern of elastic fibers 651 (e.g., a position of an elastic fiber 651 over or under a corresponding rib 652), may be configured to provide particular properties to elastic matrix 650, in addition to bulk material properties of the array of elastic fibers 651. A variety of materials may be used for the array of elastic fibers 651, such as nylon monofilaments or elastomeric threads. For example, nylon threads (e.g., 220 micrometer or 225 micrometer diameters) may be weaved with wire (e.g., 150 micrometer diameter) or fused silica fibers (e.g., 140 micrometer or 170 micrometer diameters with acrylate or polyimide coating).

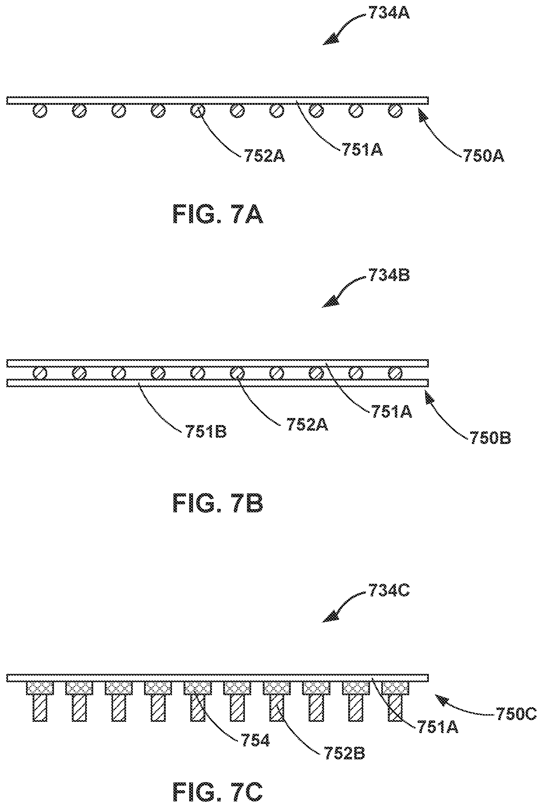

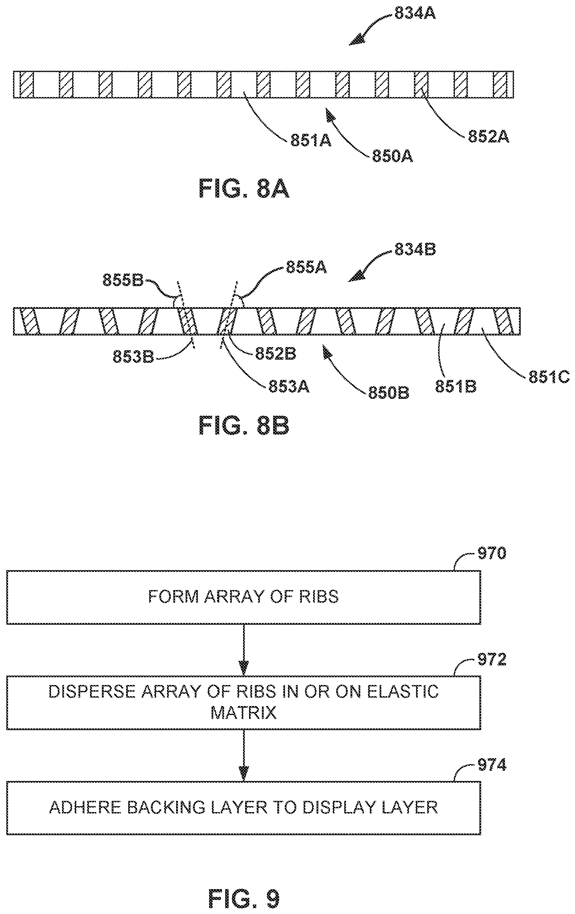

In some examples, backing layers described herein may be formed as horizontal layers. FIGS. 7A-7C are side view schematic diagrams illustrating cross-sections of a portion of backing layers 734A, 734B, 734C that includes an array of ribs 752A, 752B positioned horizontally adjacent to one or more elastic matrices 750A, 750B, in accordance with one or more aspects of this disclosure. Referring to FIG. 7A, backing layer 734A includes elastic matrix 750A formed as an elastic sheet 751A, and the array of ribs 752 is underlying elastic sheet 751A. While not shown, the array of ribs 752 may be adhered to elastic sheet 751A using an adhesive or other coupling material. As will be described further in FIG. 9 below, elastic sheet 751A and the array of ribs 752A may be formed and assembled as discrete components. In some examples, backing layers described herein may be formed from more than one elastic sheet. Referring to FIG. 7B, backing layer 734B includes elastic matrix 750A formed as a first elastic sheet 751A overlying the array of ribs 752A and a second elastic sheet 751B underlying the array of ribs 752A.

In some examples, backing layer described herein may be formed using an adhesive. Referring to FIG. 7C, backing layer 734C includes elastic matrix 750C formed as an elastic sheet 751A and an array of adhesive elements 754 coupling the array of ribs 752B to elastic sheet 751A. The array of adhesive elements 754 may be configured to adhere the array of ribs 752B to elastic sheet 751A. In some examples, the array of adhesive elements 754 may also provide various mechanical properties to elastic matrix 750C. For example, the array of adhesive element 754 may have a relatively high elastic modulus, such that the array of adhesive elements 754 may function as springs for enabling elastic sheet 751A to move with respect to the array of ribs 752B.

In some examples, backing layers described herein may be formed from vertically arranged sheets. FIGS. 8A and 8B are side view schematic diagrams illustrating a cross-section of a portion of backing layers 834A, 834B that include ribs formed from sheets laminated in an elastic matrix, in accordance with one or more aspects of this disclosure. Referring to FIG. 8A, each rib 852A and segment 851A of elastic matrix 850A may be formed from a vertically arranged sheet. As will be described further in FIG. 9, sheets of rib material and elastic material may be vertically arranged, adhered together into a bulk material, and cut across the grain into thin sheets of a desired thickness to form backing layer 834A, such as by using a wire saw, bandsaw, microtonic, or circular CNC blade. For example, ribs 852A may be formed from aluminum foil (e.g., 50 micrometer thickness) and elastic matrix 850A may be formed from EDPM sheets (e.g., 400 micrometer thickness and Shore 50A hardness). Each sheet may be formed to relatively precise thicknesses, and vertical arrangement of the sheets may enable precise positioning of rib sheets compared to methods that position the array of ribs without adjacent support structures, such as elastic material. As a result, the array of ribs 852A in backing layer 834A may have substantially uniform spacing and orientation.

In some examples, the array of ribs may be oriented off-normal from the major surface of the backing layer. Referring to FIG. 8B, each rib 852 defines an axis of orientation 853A, 853B. The array of ribs 852 may be formed by patterning a metal sheet into alternating peaks and troughs, such as convoluted or folded fin stock. In the example of FIG. 8B, the array of ribs includes ribs having at least two different axes of orientation 853A, 853B forming a lesser angle 855A, 855B with a plane of a surface of backing layer 834B. Such differences in orientation may result in segments 851B, 851C having different shapes and/or orientations. For example, elastic matrix 850B may include first segments 851B having a trapezium shape with a long side facing the overlying layer and second segments 851C having a trapezium shape with a short side facing the overlying layer. In response to bending, the long side of the first segments 851B may collapse to a greater extent than the short side of the second segments 851C, and the long side of the second segments 851C may expand to a greater extent than the short side of the first segments 851B. In some examples, angle 855A, 855B may be greater than about 60 degrees and less than 90 degrees from a plane of backing layer 834B.

FIG. 9 is a flow chart illustrating a method of forming a backing layer of a continuous display of a folding device, in accordance with one or more aspects of this disclosure. The method of FIG. 9 will be generally described with respect to FIGS. 2A, 2B, 3A, and 3B, but may be used to form backing layers having other configurations.

The method of FIG. 9 includes forming an array of ribs, such as array of ribs 352 (970). In some examples, ribs 352 may be formed as freestanding ribs 352. For example, a metal sheet, such as an aluminum sheet, may be etched to form freestanding ribs positioned in a particular pattern. As another example, metal wires may be woven with elastic fibers to leave gaps between the metal wires. In some examples, ribs 352 may be formed by a sequential rib lay-down, such as into a knit fabric, into a mold, or onto a carrier tape. In other examples, ribs 352 may be wound onto a drum and laid onto a substrate, such as a carrier tape. Regardless of a method of forming ribs 352, ribs 352 may be oriented such that each rib 352 is parallel to a folding axis of the resulting backing layer 334. For example, ribs 352 may be positioned in a particular pattern or spacing corresponding to the resulting backing layer 334.

The method of FIG. 9 includes dispersing the array of ribs in or on an elastic matrix, such as the array of ribs 352 dispersed in elastic matrix 350 (972). Dispersion in or on an elastic matrix may include any adhesion of the array of ribs on or within the elastic matrix. In some examples, such as illustrated in FIGS. 5A-5C, elastic matrix 550 may be formed between or around the array of ribs 552. For example, the array of ribs 552 may be arranged in a mold and an elastic material in a flowable state may be injected onto the array of ribs 552 and cured to form elastic matrix 550. In some examples, such as illustrated in FIG. 6, elastic matrix 650 may be formed using discrete fibers around the array of ribs 652. For example, elastic fibers 651 may be woven into the array of ribs 652. In some examples, such as illustrated in FIGS. 7A-7C, elastic matrix 750 may be formed on and/or under the array of ribs 752. For example, an adhesive may be applied to a surface of the array of ribs 752, and one or more elastic sheets 751 may be positioned on the array of ribs 752 to form the elastic matrix 750. In some examples, such as illustrated in FIGS. 8A-8B, elastic matrix 850 and the array of ribs 852 may be formed as vertically arranged sheets. For example, sheets of elastic material and rib material may be alternately positioned and adhered together to form a laminate structure. The laminate structure may be cut perpendicular to the orientation of the sheets to form backing layer 834 having the array of ribs 852 dispersed between segments 851 of elastic matrix 850.

The method of FIG. 9 includes adhering the backing layer to a display layer, such as backing layer 234 to display layer 232. For example, an adhesive may be applied to backing layer 234 and display layer 232 positioned on backing layer 234. Further layers, such as cover layer 230, may be positioned on display layer 232 to form continuous display 206.

## Claims

1. A foldable display, comprising:
a continuous display (106, 206) that includes a flexible segment (108, 208) configured to fold around a folding axis (118, 218, 353),
wherein the continuous display comprises:
a display layer (232) comprising an optical display,
a cover layer (230) overlying the display layer; and
a backing layer (234, 334, 434, 534, 634, 734, 834) underlying the display layer, wherein the backing layer comprises:
an elastic matrix (350, 450, 550, 650, 750, 850) or sheet; and
an array of ribs (352, 452, 552, 652, 752, 852) dispersed in or on the elastic matrix or sheet
and aligned substantially parallel to the folding axis;
wherein adjacent ribs of the array of ribs are separated by a spacing (466), **characterized in that**
the spacing of the ribs inside the flexible segment is different from the spacing of the ribs outside the flexible segment.

2. The foldable display of claim 1, wherein a thickness of the backing layer (434) is less than 1 millimeter; and/or
wherein a thickness (462) of the array of ribs (452) is less than 200 micrometers.

3. The foldable display of claims 1 or 2, wherein the array of ribs (452) have an elastic modulus greater than 1 gigapascal; and/or
wherein the array of ribs (452) include at least one of a metal, a carbon reinforced plastic, or a fused silica fiber.

4. The foldable display of any preceding claim, wherein the elastic matrix (450) or sheet has an elastic modulus less than 100 megapascal.

5. The foldable display of any preceding claim, wherein an elastic modulus of the array of ribs (452) is at least 10,000 times greater than an elastic modulus of the elastic matrix (450) or sheet.

6. The foldable display of any preceding claim, wherein the elastic matrix (450) or sheet includes at least one of an ethylene propylene diene monomer, EPDM, rubber, nitrile rubber, thermoplastic polyurethane, TPU, silicone, O-carboxyanhydride, OCA, acrylate, or nylon.

7. The foldable display of any preceding claim, wherein the optical display comprises an organic light-emitting diode, OLED, display or a micro light emitting diode display.

8. The foldable display of any preceding claim, wherein the elastic matrix (450) or sheet comprises a continuous elastic matrix, and
wherein the array of ribs (452) is embedded in the elastic matrix.

9. The foldable display of any of claims 1-7, wherein the elastic matrix or sheet comprises an elastic sheet, and
wherein the array of ribs is underlying the elastic sheet; optionally
wherein the elastic sheet is a first elastic sheet,
wherein the elastic matrix or sheet further comprises a second elastic sheet, and
wherein the array of ribs is in between the first and second elastic sheets.

10. The foldable display of any preceding claim, wherein each rib of the array of ribs (452) defines an axis of orientation, and
wherein the array of ribs includes ribs having at least two different axes of orientation.

11. The foldable display of any of claims 1-7, wherein the elastic matrix (450) or sheet comprises an array of elastic fibers aligned substantially perpendicular to the folding axis (118), and
wherein the array of elastic fibers is woven with the array of ribs.

12. The foldable display of any preceding claim, wherein the backing layer (434) further comprises an adhesive between the array of ribs (452) and the elastic matrix (450) or sheet.

13. A folding display device (100), comprising:
a housing (101) comprising:
a first assembly (102);
a second assembly (104); and
a hinge assembly (114) coupled to the first and second assemblies and defining the folding axis (118); and
a foldable display according to any preceding claim coupled to the housing.

14. The folding display device (100) of claim 13,
wherein when the housing (101) is fully opened about the hinge assembly (114), an inner surface of the first assembly (102) is substantially coplanar with an inner surface of the second assembly (104), and
wherein when the housing is fully closed about the hinge assembly, the flexible segment is configured to fold around the folding axis (118) to a bend radius.

15. The folding display device (100) of claims 13 or 14, further comprising:
memory configured to store executable instructions; and
processing circuitry configured to execute the instructions;
wherein the continuous display is configured to display information in response to the execution of the instructions.

## Patentansprüche

1. Faltbares Display, umfassend:
ein durchgehendes Display (106, 206), das ein flexibles Segment (108, 208) umfasst, das dazu konfiguriert ist, sich um eine Faltachse (118, 218, 353) zu falten, wobei das durchgehende Display Folgendes umfasst:
eine Displayschicht (232), die ein optisches Display umfasst;
eine Deckschicht (230), die über der Displayschicht liegt; und
eine Rückseitenschicht (234, 334, 434, 534, 634, 734, 834), die unter der Displayschicht liegt, wobei die Rückseitenschicht Folgendes umfasst:
eine elastische Matrix (350, 450, 550, 650, 750, 850) oder Folie; und
eine Rippenanordnung (352, 452, 552, 652, 752, 852), die in oder auf der elastischen Matrix oder Folie verteilt und im Wesentlichen parallel zur Faltachse ausgerichtet ist;
wobei benachbarte Rippen der Rippenanordnung durch einen Abstand (466) getrennt sind, **dadurch gekennzeichnet, dass**
sich der Abstand der Rippen innerhalb des flexiblen Segments von dem Abstand der Rippen außerhalb des flexiblen Segments unterscheidet.

2. Faltbares Display nach Anspruch 1, wobei eine Dicke der Rückseitenschicht (434) weniger als 1 Millimeter beträgt; und/oder
wobei eine Dicke (462) der Rippenanordnung (452) weniger als 200 Mikrometer beträgt.

3. Faltbares Display nach Anspruch 1 oder 2, wobei die Rippenanordnung (452) einen Elastizitätsmodul von mehr als 1 Gigapascal aufweist; und/oder
wobei die Rippenanordnung (452) mindestens eines von einem Metall, einem kohlenstoffverstärkten Kunststoff oder einer Quarzglasfaser umfasst.

4. Faltbares Display nach einem der vorhergehenden Ansprüche, wobei die elastische Matrix (450) oder Folie einen Elastizitätsmodul von weniger als 100 Megapascal aufweist.

5. Faltbares Display nach einem der vorhergehenden Ansprüche, wobei ein Elastizitätsmodul der Rippenanordnung (452) mindestens 10.000-mal größer als ein Elastizitätsmodul der elastischen Matrix (450) oder Folie ist.

6. Faltbares Display nach einem der vorhergehenden Ansprüche, wobei die elastische Matrix (450) oder Folie mindestens eines von einem Ethylen-Propylen-Dien-Monomer, EPDM, Kautschuk, Nitrilkautschuk, thermoplastischem Polyurethan, TPU, Silikon, O-Carboxyanhydrid, OCA, Acrylat oder Nylon umfasst.

7. Faltbares Display nach einem der vorhergehenden Ansprüche, wobei das optische Display ein Display mit organischen Leuchtdioden, OLED, oder ein Display mit Mikroleuchtdioden umfasst.

8. Faltbares Display nach einem der vorhergehenden Ansprüche, wobei die elastische Matrix (450) oder Folie eine durchgehende elastische Matrix umfasst, und
wobei die Rippenanordnung (452) in die elastische Matrix eingebettet ist.

9. Faltbares Display nach einem der Ansprüche 1 bis 7, wobei die elastische Matrix oder Folie eine elastische Folie umfasst, und
wobei die Rippenanordnung unter der elastischen Folie liegt; optional
wobei die elastische Folie eine erste elastische Folie ist, wobei die elastische Matrix oder Folie ferner eine zweite elastische Folie umfasst, und
wobei sich die Rippenanordnung zwischen der ersten und der zweiten elastischen Folie befindet.

10. Faltbares Display nach einem der vorhergehenden Ansprüche, wobei jede Rippe der Rippenanordnung (452) eine Orientierungsachse definiert, und
wobei die Rippenanordnung Rippen mit mindestens zwei verschiedenen Orientierungsachsen umfasst.

11. Faltbares Display nach einem der Ansprüche 1 bis 7, wobei die elastische Matrix (450) oder Folie eine Anordnung von elastischen Fasern umfasst, die im Wesentlichen senkrecht zur Faltachse (118) ausgerichtet sind, und
wobei die Anordnung von elastischen Fasern mit der Rippenanordnung verwoben ist.

12. Faltbares Display nach einem der vorhergehenden Ansprüche, wobei die Rückseitenschicht (434) ferner einen Klebstoff zwischen der Rippenanordnung (452) und der elastischen Matrix (450) oder Folie umfasst.

13. Faltbare Displayvorrichtung (100), umfassend:
ein Gehäuse (101), umfassend:
eine erste Baugruppe (102);
eine zweite Baugruppe (104); und
eine Scharnierbaugruppe (114), die mit der ersten und der zweiten Baugruppe gekoppelt ist und die Faltachse (118) definiert; und
ein faltbares Display nach einem der vorhergehenden Ansprüche, das mit dem Gehäuse gekoppelt ist.

14. Faltbare Displayvorrichtung (100) nach Anspruch 13,
wobei, wenn das Gehäuse (101) um die Scharnierbaugruppe (114) vollständig geöffnet ist, eine Innenfläche der ersten Baugruppe (102) im Wesentlichen koplanar mit einer Innenfläche der zweiten Baugruppe (104) ist, und
wobei, wenn das Gehäuse um die Scharnierbaugruppe vollständig geschlossen ist, das flexible Segment dazu konfiguriert ist, sich um die Faltachse (118) auf einen Biegeradius zu falten.

15. Faltbare Displayvorrichtung (100) nach Anspruch 13 oder 14, ferner umfassend:
einen Speicher, der dazu konfiguriert ist, ausführbare Anweisungen zu speichern; und
eine Verarbeitungsschaltung, die dazu konfiguriert ist, die Anweisungen auszuführen;
wobei das durchgehende Display dazu konfiguriert ist, als Reaktion auf die Ausführung der Anweisungen Informationen anzuzeigen.

## Revendications

1. Écran pliable, comprenant :
un écran continu (106, 206) comportant un segment flexible (108, 208) configuré pour se plier autour d'un axe de pliage (118, 218, 353), dans lequel l'écran continu comprend :
une couche d'affichage (232) comprenant un écran optique ;
une couche de couverture (230) recouvrant la couche d'affichage ; et
une couche de support (234, 334, 434, 534, 634, 734, 834) sous-jacente à la couche d'affichage, dans lequel la couche de support comprend :
une matrice élastique (350, 450, 550, 650, 750, 850) ou feuille élastique ; et
un réseau de nervures (352, 452, 552, 652, 752, 852) dispersées dans ou sur la matrice ou feuille élastique et alignées sensiblement parallèlement à l'axe de pliage ;
dans lequel des nervures adjacentes du réseau de nervures sont séparées par un espacement (466), **caractérisé en ce que**
l'espacement des nervures à l'intérieur du segment flexible est différent de l'espacement des nervures à l'extérieur du segment flexible.

2. Écran pliable selon la revendication 1, dans lequel une épaisseur de la couche de support (434) est inférieure à 1 millimètre ; et/ou
dans lequel une épaisseur (462) du réseau de nervures (452) est inférieure à 200 micromètres.

3. Écran pliable selon les revendications 1 ou 2, dans lequel le réseau de nervures (452) a un module d'élasticité supérieur à 1 gigapascal ; et/ou
dans lequel le réseau de nervures (452) comporte au moins l'un parmi un métal, une matière plastique renforcée de carbone ou une fibre de silice fondue.

4. Écran pliable selon l'une quelconque revendication précédente, dans lequel la matrice élastique (450) ou feuille élastique a un module d'élasticité inférieur à 100 mégapascals.

5. Écran pliable selon l'une quelconque revendication précédente, dans lequel un module d'élasticité du réseau de nervures (452) est au moins 10 000 fois supérieur à un module d'élasticité de la matrice élastique (450) ou feuille élastique.

6. Écran pliable selon l'une quelconque revendication précédente, dans lequel la matrice élastique (450) ou feuille élastique comporte au moins l'un parmi un caoutchouc terpolymère éthylène-propylène-diène, EPDM, du caoutchouc nitrile, du polyuréthane thermoplastique, TPU, du silicone, un O-carboxyanhydride, OCA, de l'acrylate ou du nylon.

7. Écran pliable selon l'une quelconque revendication précédente, dans lequel l'écran optique comprend un écran à diodes électroluminescentes organiques, OLED, ou un écran à micro-diodes électroluminescentes.

8. Écran pliable selon l'une quelconque revendication précédente, dans lequel la matrice élastique (450) ou feuille élastique comprend une matrice élastique continue, et
dans lequel le réseau de nervures (452) est enrobé dans la matrice élastique.

9. Écran pliable selon l'une quelconque des revendications 1 à 7, dans lequel la matrice ou feuille élastique comprend une feuille élastique, et
dans lequel le réseau de nervures est sous-jacent à la feuille élastique ; éventuellement
dans lequel la feuille élastique est une première feuille élastique,
dans lequel la matrice ou feuille élastique comprend en outre une seconde feuille élastique, et
dans lequel le réseau de nervures se trouve entre la première et la seconde feuille élastique.

10. Écran pliable selon l'une quelconque revendication précédente, dans lequel chaque nervure du réseau de nervures (452) définit un axe d'orientation, et
dans lequel le réseau de nervures comporte des nervures ayant au moins deux axes d'orientation différents.

11. Écran pliable selon l'une quelconque des revendications 1 à 7, dans lequel la matrice élastique (450) ou feuille élastique comprend un réseau de fibres élastiques alignées sensiblement perpendiculairement à l'axe de pliage (118), et
dans lequel le réseau de fibres élastiques est tissé avec le réseau de nervures.

12. Écran pliable selon l'une quelconque revendication précédente, dans lequel la couche de support (434) comprend en outre un adhésif entre le réseau de nervures (452) et la matrice élastique (450) ou feuille élastique.

13. Dispositif à écran pliable (100), comprenant :
un boîtier (101) comprenant :
un premier ensemble (102) ;
un second ensemble (104) ; et
un ensemble de charnière (114) accouplé aux premier et second ensembles et définissant l'axe de pliage (118) ; et
un écran pliable selon l'une quelconque revendication précédente accouplé au boîtier.

14. Dispositif à écran pliable (100) selon la revendication 13, dans lequel, lorsque le boîtier (101) est entièrement ouvert autour de l'ensemble de charnière (114), une surface interne du premier ensemble (102) est sensiblement coplanaire avec une surface interne du second ensemble (104), et
dans lequel, lorsque le boîtier est entièrement fermé autour de l'ensemble de charnière, le segment flexible est configuré pour se plier autour de l'axe de pliage (118) selon un rayon de courbure.

15. Dispositif à écran pliable (100) selon la revendication 13 ou 14, comprenant en outre :
une mémoire configurée pour stocker des instructions exécutables ; et
des circuits de traitement configurés pour exécuter les instructions ;
dans lequel l'écran continu est configuré pour afficher des informations en réponse à l'exécution des instructions.
